# EUROPÄISCHE PATENTANMELDUNG

(11) **EP 4 563 732 A1**
(43) Veröffentlichungstag der Anmeldung: **04.06.2025**
(21) Anmeldenummer: 23213445.2
(22) Anmeldetag: 30.11.2023
(51) Int. Cl.: C30B 15/20, C30B 15/30, C30B 15/22, C30B 29/06, C30B 33/00

(54) **VERFAHREN UND VORRICHTUNG ZUR HERSTELLUNG EINES KRISTALLSTABS UNTER VERMINDERTER PENDELAUSLENKUNG WÄHREND DES ZIEHPROZESSES**

(71) Anmelder: Siltronic AG, 81677 München (DE)
(72) Erfinder: Zeman, Otto, 84539 Ampfing (DE); Knerer, Dieter, 84533 Haiming (DE); Mangelberger, Karl, 5122 Ach (AT); Zwirglmaier, Hermann, 84576 Teising (DE)
(74) Vertreter: Hasenhütl, Eva

(57) **Zusammenfassung**

Die Erfindung betrifft ein Verfahren zur Herstellung eines Einkristallstabs, insbesondere aus Silizium, mittels einer Ziehvorrichtung (110) einer Kristallziehvorrichtung (100), wobei ein Pendeldrehpunkt D durch die Kristallziehvorrichtung (100) definiert wird, durch welchen im Wesentlichen entlang einer Höhenachse eine definierte Kristallpendelruheachse verläuft, wobei während wenigstens eines Ziehprozesses über die Ansteuerung der Ziehvorrichtung (110) mit einer Steuervorrichtung (120) ein im Wesentlichen sukzessiv fortschreitender Einkristallstababschnitt mit einer einhergehenden im Wesentlichen sukzessiv fortschreitenden zugeordneten Einkristalllänge aus einer Schmelze gemäß einer einstellbaren, veränderbaren Soll-Ziehgeschwindigkeit der Ziehvorrichtung (110) zu dem Einkristallstab gezogen wird. Während wenigstens eines Zeitabschnittes des Ziehprozesses wird eine derart gezielte, veränderbare Einstellung der Soll-Ziehgeschwindigkeit über eine gezielte Ansteuerung der Ziehvorrichtung (110) über die Steuervorrichtung (120) vorgenommen, dass sich jeweils nach einer vorgenommenen veränderten Einstellung der Soll-Ziehgeschwindigkeit für den weiter folgenden Ziehprozess maximale, auf die Kristallpendelruheachse bezogene, Pendelauslenkungen des fortschreitenden Einkristallstababschnitts als Funktion der fortschreitenden Ziehzeit und/oder fortschreitenden Einkristalllänge ausbilden, deren Beträge und/oder deren Differenzbeträge aus aufeinanderfolgenden Beträgen, wenigstens abschnittsweise reduziert sind.

## Beschreibung

### Technisches Gebiet

Die Erfindung betrifft ein Verfahren zur Herstellung eines Einkristallstabs unter verminderter Pendelauslenkung sowie die weiterverarbeitende Herstellung von Scheiben aus Halbleitermaterial. Die Erfindung betrifft weiterhin eine Kristallziehvorrichtung sowie die Verwendung der Kristallziehvorrichtung zur Reduzierung von Pendelauslenkungen. Schließlich betrifft die Erfindung ein Computerprogramm zur Reduzierung von Pendelauslenkungen sowie ein computerlesbares Medium, auf dem dieses Computerprogramm gespeichert ist.

### Stand der Technik und technische Aufgabe

Vornehmlich bei Kristallziehvorrichtungen, welche mit einer Ziehvorrichtung nach Art einer Seilpendelvorrichtung betrieben werden, ist bekannt, dass Pendelbewegungen der am Ziehseil hängenden Masseeinheit während des eigentlichen Kristallziehprozesses (d.h. insbesondere der wachsende Kristallstab), aber auch während dem eigentlichen Kristallziehprozess vorgelagerter oder nachgelagerter Prozessschritte an der am Ziehseil hängenden Masseeinheit (d.h. u.a. betreffend die Bewegung der Schmelzabdeckung oder anderer Komponenten der Kristallziehvorrichtung, die beispielsweise gehoben werden müssen) auftreten. Hierbei kann es vorkommen, dass eine maximale, auf eine Kristallpendelruheachse bezogene, Pendelauslenkung der Masseeinheit derart große Beträge annimmt, dass die Masseeinheit beispielsweise mit dem Tiegelrand des Tiegels der Kristallziehvorrichtung kollidiert und eine entsprechende Schädigung an dem Tiegel und insbesondere an der hängenden Masseeinheit, d.h. beispielsweise an dem im Herstellungsprozess befindlichen Kristallstab oder an Komponenten der Kristallziehvorrichtung verursacht wird.

Im Hinblick auf den eigentlichen Kristallziehprozess treten jedoch schon weit vor Kollision des wachsenden Kristallstabs mit dem Tiegelrand Schädigungen an dem wachsenden Kristallstab auf: schon bei geringer Pendelauslenkung kommt es zu Ausbeuteverlusten, da der Kristall nicht mehr zylindrisch wächst bzw. aus der Schmelze gezogen wird. Ein derartiges Kristallwachstum ist naturgemäß nachteilig und macht den hergestellten Kristallstab(abschnitt) unbrauchbar.

Um das Kristallziehen auch innerhalb der Resonanzfrequenz des Systems zu ermöglich, ist eine aktive Gegensteuerung zur Pendelbewegung erforderlich.

Aus dem Stand der Technik ist zur Lösung dieser Problematik eine aktive Regelung an der Kristallziehvorrichtung mittels eines "X-Y-Tisches" unterhalb des Seildrehkopfes, wie beispielsweise in DE 102009024472 A1 beschrieben, bekannt. Hierbei wird zur Reduzierung von Pendelauslenkungen während des Ziehprozesses der Seildrehkopf über den X-Y-Tisch entsprechend in Querrichtungen (entlang der X-Richtung und Y-Richtung) zur Höhenachse verschoben. Das Vorsehen eines derartigen, verschiebbaren X-Y-Tisches unterhalb des Seildrehkopfes zur Entgegenwirkung von Pendelauslenkungen während des Ziehprozesses erfordert jedoch einen komplexen konstruktiven sowie steuerungstechnischen Aufbau.

Der vorliegenden Erfindung liegt daher die objektive, technische Aufgabe zu Grunde, auf einfache Weise insbesondere ein Verfahren sowie eine Vorrichtung zur Herstellung eines Einkristallstabs unter verminderter Pendelauslenkung bereitzustellen, welche die oben genannten Nachteile nicht oder zumindest in geringerem Ausmaß aufweisen und welche insbesondere ohne dem Vorsehen eines verschiebbaren X-Y-Tisches unterhalb eines Seildrehkopfes zur Entgegenwirkung bzw. Reduzierung von Pendelauslenkungen auskommt.

Gelöst wird die Aufgabe gemäß einem ersten Aspekt durch ein Verfahren zur Herstellung eines Einkristallstabs gemäß den Merkmalen nach Anspruch 1, gemäß einem zweiten Aspekt durch eine Kristallziehvorrichtung nach den Merkmalen nach Anspruch 9, gemäß einem dritten Aspekt durch deren Verwendung zur Reduzierung von Pendelauslenkungen nach Anspruch 11, sowie schließlich gemäß einem vierten Aspekt durch ein Computerprogramm zur Reduzierung von Pendelauslenkungen gemäß den Merkmalen nach Anspruch 12. Weiterhin betrifft die Erfindung ein computerlesbares Medium nach Anspruch 13, auf dem dieses Computerprogramm gespeichert ist. Schließlich betrifft die Erfindung ausgehend von dem erfindungsgemäßen Verfahren bzw. seiner bevorzugten Varianten zur Herstellung eines Einkristallstabs unter verminderter Pendelauslenkung die weiterverarbeitende Herstellung von Scheiben aus Halbleitermaterial gemäß Anspruch 14.

Der Erfindung liegt hierbei die technische Lehre zugrunde, dass man auf einfache Weise und insbesondere ohne die eben beschriebenen konstruktiven zusätzlichen Aufbauten einen

Kristallstab fertigen kann, welcher unter verminderter Pendelauslenkung an der Kristallziehvorrichtung gezogen wurde, indem man eine Reduzierung, insbesondere Dämpfung, der während des Ziehens auftretenden maximalen, auf eine Kristallpendelruheachse bezogene, Pendelauslenkung ausschließlich über eine gezielte, und insbesondere kontinuierliche und veränderbare, Einstellung der Soll-Ziehgeschwindigkeit vornimmt. Mit anderen Worten hat die gegenwärtige Erfindung erkannt, dass es für eine effektive Reduzierung bzw. Dämpfung der Pendelauslenkung während des Ziehens ausreichend ist, die Soll-Ziehgeschwindigkeit in Reaktion auf das aktuelle Ergebnis der Pendelauslenkung anzupassen und dies insbesondere anhand von vorgebbaren Schaltschritten und Schaltkriterien folgend (betreffend u.a. den Verlauf, die Änderung und den Betrag der Soll-Ziehgeschwindigkeit) durchzuführen.

### Beschreibung der Erfindung

Gemäß einem ersten Aspekt betrifft die Erfindung daher ein Verfahren zur Herstellung eines Einkristallstabs, insbesondere aus Silizium, mittels einer Ziehvorrichtung einer Kristallziehvorrichtung, wobei ein Pendeldrehpunkt D durch die Kristallziehvorrichtung, insbesondere durch die Ziehvorrichtung, definiert wird, durch welchen im Wesentlichen entlang einer Höhenachse eine definierte Kristallpendelruheachse verläuft. Während wenigstens eines Ziehprozesses wird hierbei über die Ansteuerung der Ziehvorrichtung mit der Steuervorrichtung ein im Wesentlichen sukzessiv fortschreitender Einkristallstababschnitt mit einer einhergehenden im Wesentlichen sukzessiv fortschreitenden zugeordneten Einkristalllänge aus einer Schmelze gemäß einer einstellbaren, veränderbaren Soll-Ziehgeschwindigkeit der Ziehvorrichtung zu dem Einkristallstab gezogen.

Erfindungsgemäß ist hierbei vorgesehen, dass während wenigstens eines Zeitabschnittes des Ziehprozesses eine derart gezielte, veränderbare Einstellung der Soll-Ziehgeschwindigkeit über eine gezielte Ansteuerung der Ziehvorrichtung über eine Steuervorrichtung vorgenommen wird, dass sich jeweils nach einer vorgenommenen veränderten Einstellung der Soll-Ziehgeschwindigkeit für den weiter folgenden Ziehprozess maximale, auf die Kristallpendelruheachse bezogene, Pendelauslenkungen Ä des fortschreitenden Einkristallstababschnitts als Funktion der fortschreitenden Ziehzeit und/oder fortschreitenden Einkristalllänge ausbilden, deren Beträge und/oder deren Differenzbeträge aus aufeinanderfolgenden Beträgen, wenigstens abschnittsweise reduziert sind, insbesondere im Vergleich zu Beträgen und/oder Differenzbeträgen von maximalen Referenzpendelauslenkungen Â_{R}, die sich alternativ zu dem Ziehprozess in einem Referenzziehprozess jeweils bei einer identischen fortschreitenden Ziehzeit und/oder identischen fortschreitenden Einkristallstablänge an einem fortschreitenden Referenzeinkristallstababschnitt ausbilden würden, in welchem ein Referenzeinkristallstab gemäß einem referenzprozesstypischen Referenz-Soll-Soll-Ziehgeschwindigkeitsprofil gezogen wird.

Mit dem erfindungsgemäßen Verfahren wird in einfacher Weise erzielt, dass eine Reduzierung (bzw. Dämpfung), der auftretenden maximalen, auf die Kristallpendelruheachse bezogene, Pendelauslenkung innerhalb des wenigstens einen Zeitabschnitts ausschließlich über eine gezielte, und insbesondere kontinuierliche, Einstellung der Soll-Ziehgeschwindigkeit vorgenommen wird. Vorzugsweise wird diese Einstellung der Soll-Ziehgeschwindigkeit über eine gezielte Ansteuerung der Ziehvorrichtung über jene Steuervorrichtung der Kristallziehvorrichtung vorgenommen, welche ohnehin bei gattungsgemäßen Kristallziehvorrichtungen vorgesehen ist. Es ändern sich also nur die Ansteuerungsbefehle zur gezielten, veränderbaren Einstellung der Soll-Ziehgeschwindigkeit, insbesondere gemäß den weiter unten beschriebenen Schaltkriterien bzw. Schaltschritten), ohne das weitere Einheiten zur Ansteuerung an der Kristallziehvorrichtung oder in der Umgebung der Kristallziehvorrichtung bereitgestellt werden müssten. Mit anderen Worten kann an einer konventionellen (gattungsgemäßen) Kristallziehvorrichtung die Pendelauslenkungsreduzierung gemäß der Erfindung durchgeführt werden und dies mittels der Ausführung des erfindungsgemäßen Computerprogramms (wie weiter unten beschrieben) durch eine ohnehin bei gattungsgemäßen Verfahren bzw. Kristallziehanlagen bereitgestellte Computervorrichtung (umfassend eine Prozessoreinheit).

Mit dem erfindungsgemäßen Verfahren werden die eingangs beschriebenen Nachteile in Verbindung mit im dem Stand der Technik angeführten Lösungsansätze zur Reduzierung von Pendelauslenkungen überwunden.

Unter dem Referenzziehprozess ist ein (gesondert zu dem erfindungsgemäßen Verfahren durchgeführter) Vergleichsprozess zu verstehen, der also im Moment der Durchführung des Verfahrens zur Herstellung des Einkristallstabs nicht (simultan) an der Kristallziehvorrichtung durchgeführt wird. Er dient als Vergleichsprozess im Sinne eines Process of Reference (POR) und ermöglicht die Quantifizierung des Effekts der erfindungsgemäßen Reduzierung bzw. Dämpfung der maximalen Pendelauslenkung. Vorzugsweise folgt dabei das referenzprozesstypische Referenz-Soll-Ziehgeschwindigkeitsprofil einem Profil prozesstypischen Verlauf von konventionellen Kristallziehanlagen.

Der "im Wesentlichen sukzessiv fortschreitende Einkristallstababschnitt" im Sinne der Erfindung, der während des Ziehprozesses aus der Schmelze gezogen wird, kann auch temporäre Rückschmelzvorgänge beinhalten. Mit anderen Worten ist nicht zwingend notwendig, dass sich der Kristallstab durchgehend im wachsenden Zustand befindet.

Unter "wenigstens abschnittsweise" im Sinne der Erfindung ist zu verstehen, dass eine (im Vergleich zum Referenzziehprozess) Reduzierung der Beträge und/oder deren Differenzbeträge aus aufeinanderfolgenden Beträgen der Pendelauslenkungen Ä sich jeweils auch nur abschnittsweise während der fortschreitenden Ziehzeit und/oder fortschreitenden Einkristalllänge ausbilden kann. Beispielsweise ist es möglich, dass sich mittels des erfindungsgemäßen Verfahrens eine hohe Reduzierung der Differenzbeträge aus aufeinanderfolgenden Beträgen der Pendelauslenkungen Â an einem zeitlichen Abschnitt am Anfang des Ziehprozesses (insbesondere am Anfang des Zeitabschnitts des Ziehprozesses) ausbildet und sich gegen Mitte oder Ende des Ziehprozesses hin (insbesondere gegen Mitte oder Ende des Zeitabschnitts des Ziehprozesses) hingegen eine hohe Reduzierung der Beträge der Pendelauslenkungen Â an sich (gegenüber dem Referenzziehprozess) ausbildet. Diese Beeinflussung des resultierenden Auslenkungsverhaltens des Einkristallstababschnitts kann nun durch die gezielte, veränderbare Einstellung der Soll-Ziehgeschwindigkeit (über die entsprechende Ansteuerung der Ziehvorrichtung über die Steuervorrichtung) erreicht werden. Dank der flexiblen Gestaltungsmöglichkeit der gezielten Einstellung der Soll-Ziehgeschwindigkeit, insbesondere in Abhängigkeit eines vorgebbaren Pendelauslenkungsauslöseschwellwerts, ergibt sich eine Vielzahl von weiteren Verlaufsvarianten.

Das erfindungsgemäße Verfahren eignet sich sowohl für die Durchführung an einer Kristallziehvorrichtung mit einer Ziehvorrichtung nach Art einer Seilpendelvorrichtung, als auch für die Durchführung an einer Kristallziehvorrichtung mit einer Ziehvorrichtung nach Art einer konventionellen CZ-Ziehvorrichtung mit einer Gestängeeinheit. Die besonders vorteilhaften Effekte der Erfindung kommen jedoch insbesondere bei der Durchführung an einer Kristallziehvorrichtung mit einer Ziehvorrichtung nach Art einer Seilpendelvorrichtung zum Tragen.

Bei bevorzugten Varianten wird der Drehpunkt D durch die Ziehvorrichtung definiert und ist dieser räumlich zugeordnet. Hierbei kann bei Ausführungen der Ziehvorrichtung nach Art einer Seilpendelvorrichtung der vorgesehene Seildrehkopf gemäß konventionellen Seildrehkopfausführungen, jedoch ohne einem Vorsehen oder Zusammenwirken mit einem X-Y-Tisch oder anderweitigen (physischen) Einheit, ausgestaltet sein und auf konventionelle Weise (über eine Antriebseinheit in Form einer Motoreinheit) angetrieben werden. Mit anderen Worten ist keine konstruktive Änderung an dem oder Zubau an dem Seildrehkopf zur Durchführung des erfindungsgemäßen Verfahrens erforderlich.

Bei bevorzugten Variante verweilt der Drehpunkt D während des Ziehprozesses im Wesentlichen in einem ortsfesten Zustand bzw. vollführt im Wesentlichen keine Relativbewegungen. "Im Wesentlichen" bedeutet in diesem Zusammenhang jedoch, dass sich beispielsweise bei Ausführung der Ziehvorrichtung nach Art einer Seilpendelvorrichtung der Drehpunkt D naturgemäß infolge der Aufwicklung des Seils an der Trommel während des Ziehprozesses insoweit eine örtlich veränderbare Lage des Drehpunkts D innerhalb gewisser Grenzen ergeben kann, da sich bei gewissen Ausführungen während der Aufwicklung des Ziehseils der Abrollpunkt des Ziehseils an der Trommel verschiebt. Dieser Einfluss auf die Ergebnisse der Pendelauslenkungsermittlung ist jedoch vernachlässigbar.

Bei besonders vorteilhaften Varianten ist vorzugsweise vorgesehen, dass die veränderbare Einstellung der Soll-Ziehgeschwindigkeit in Reaktion darauf vorgenommen wird, dass die maximale Pendelauslenkung einen vorgebbaren Pendelauslenkungsauslöseschwellwert erreicht oder übersteigt oder unterschreitet, der im Bereich von 0 mm bis 100,0 mm, vorzugsweise im Bereich von 0,1 mm bis 10,0 mm, weiter vorzugsweise im Bereich von 0,5 mm bis 3,0 mm liegt.

Die Ansteuerung im Sinne der Erfindung umfasst auch die Regelung und die Regelungsschritte bzw. die Steuervorrichtung im Sinne der Erfindung beinhaltet auch eine Regelungseinheit, die dazu ausgebildet ist, den ständigen Abgleich mit den vorgebbaren Schwellwerten, hier insbesondere dem wenigstens einen Pendelauslenkungsauslöseschwellwert, durchzuführen und in Abhängigkeit des Ergebnisses des Abgleichs, insbesondere anhand von vorgebbaren Schaltkriterien und vorgebbaren Schaltschritten folgend, die Soll-Ziehgeschwindigkeit gezielt veränderbar einzustellen (oder bis auf weiteres auf dem aktuellen Niveau eingestellt beizubehalten).

Der Pendelauslöseschwellwert repräsentiert ein Maß für die Stärke der Kristallpendelbewegung, ab dem die aktive, gezielte veränderbare Einstellung Soll-Ziehgeschwindigkeit vorgenommen werden soll; mit anderen Worten, ab welcher Auslenkungsschwelle die Reduzierung bzw. Dämpfung durch entsprechende Ansteuerung der Ziehvorrichtung über die Steuervorrichtung mit einer vorgebbaren Soll-Ziehgeschwindigkeit vorgenommen werden soll.

Bei besonders vorteilhaften Varianten ist vorzugsweise vorgesehen, dass während des wenigstens einen Zeitabschnitts des Ziehprozesses, mittels einer Pendelbewegungsermittlungsvorrichtung wenigstens der Verlauf der aktuellen, maximalen Pendelauslenkung des Einkristallstababschnitts als Funktion der aktuellen Ziehzeit und/oder aktuellen Einkristalllänge ermittelt wird, wobei mittels der Pendelbewegungsermittlungsvorrichtung kontinuierlich die Ergebnisse der Ermittlung zur weiteren Verwendung an eine Anzeigevorrichtung übermittelt werden. Zusätzlich oder alternativ werden die Ergebnisse der Ermittlung zur weiteren Verwendung an eine Speichervorrichtung übermittelt. Die Anzeigevorrichtung und die Speichervorrichtung sind vorzugsweise Teil einer Computervorrichtung umfassend eine Prozessoreinheit. Insbesondere wird ein aktuelles Ergebnis weiterhin an die Steuervorrichtung übermittelt. Dort kann die Steuervorrichtung die Soll-Ziehgeschwindigkeit gezielt, insbesondere gemäß wenigstens einem Schaltschritt und wenigstens einem vorgebbaren Schaltkriterium folgend (insbesondere wie weiter unten beschrieben), veränderbar einstellen, wenn die aktuelle maximale Pendelauslenkung einen vorgebbaren Pendelauslenkungsauslöseschwellwert erreicht oder unterschreitet oder überschreitet.

Bei bevorzugten Varianten ist vorzugsweise die Pendelbewegungsermittlungsvorrichtung oder Komponenten der Pendelbewegungsermittlungsvorrichtung, insbesondere eine Verarbeitungsvorrichtung der Pendelbewegungsermittlungsvorrichtung, physisch einer Computervorrichtung (umfassend eine Prozessoreinheit) örtlich zugeordnet, vorzugweise in diese integriert.

Grundsätzlich kann der Verlauf der aktuellen, maximalen Pendelauslenkung des Einkristallstababschnitts als Funktion der aktuellen Ziehzeit und/oder der aktuellen Einkristalllänge auf beliebige Art und Weise ermittelt werden. Beispielsweise kann dieser Verlauf mittels einer Pendelbewegungsermittlungsvorrichtung ermittelt werden, bei der das jeweilige aktuelle Ergebnis der maximalen Pendelauslenkung über eine Gewichtsmessung bestimmt wird. Bei besonders vorteilhaften Varianten ist allerdings vorzugsweise vorgesehen, dass eine Kameravorrichtung einer vorgesehenen Pendelbewegungsermittlungsvorrichtung wenigstens einen Bildaufnahmebereich umfassend wenigstens einen Abschnitt einer Umlaufkante zwischen dem fortschreitenden Einkristallstababschnitt und der Schmelze kontinuierlich als Funktion der Zeit aufzeichnet, und eine Verarbeitungsvorrichtung der Pendelbewegungsermittlungsvorrichtung wenigstens für den Abschnitt der Umlaufkante mit Mitteln der computerbasierten Bildverarbeitung deren zeitabhängige absoluten und relativen Ortskoordinaten ermittelt (d.h. die relativen Ortskoordinaten des Abschnitts der aktuell auslenkten Umlaufkante werden in Bezug auf die ideale Lage der Umlaufkante (d.h. mittig in der Kristallpendelruheachse) angegeben) und auf Basis dieser absoluten und relativen Ortskoordinaten wenigstens einen zeitabhängigen und/oder kristalllängenabhängigen Verlauf des Abschnitts der Umlaufkante des Kristallstababschnitts nach Art von Pendelschwingungen des Kristallstababschnitts in Bezug auf die Kristallpendelruheachse und um den Pendeldrehpunkt D ermittelt, und für jede Pendelschwingung n, die zugeordnete Periodendauer T, Nulldurchgangszeitpunkt t sowie die maximale Pendelauslenkung Ä ermittelt. Vorzugsweise ist weiterhin vorgesehen, dass die Verarbeitungsvorrichtung weiterhin wenigstens den Verlauf der aktuellen, maximalen Pendelauslenkung des Einkristallstababschnitts als Funktion der aktuellen Ziehzeit und/oder der aktuellen Einkristalllänge ermittelt. Vorzugsweise wird das jeweilige aktuelle Ergebnis der (maximalen) Pendelauslenkung für die zugeordnete Pendelschwingung ausgehend von den zeitlich zugeordneten absoluten und relativen Ortskoordinaten des Abschnitts der auslenkten Umlaufkante ermittelt. Das Ergebnis wird vorzugsweise in Bezug auf die Kristallpendelruheachse in einer Ebene rechtwinkelig zu der Kristallpendelruheachse angegeben.

Bei besonders vorteilhaften Varianten ist vorzugsweise vorgesehen, dass wenigstens während des Zeitabschnittes des Ziehprozesses die Ziehvorrichtung, angesteuert über die Steuervorrichtung, die Einstellung der Soll-Ziehgeschwindigkeit in Abhängigkeit des aktuellen Ergebnisses der maximalen Pendelauslenkung gemäß wenigstens einem der folgenden Schaltschritte und einem vorgebbaren Schaltkriterium folgend vornimmt:
I) Gemäß einem ersten Schaltkriterium wird ein erster Schaltschritt vorzugsweise wie folgt ausgeführt: solange das aktuell ermittelte Ergebnis der maximalen Pendelauslenkung Ä unter einem vorgebbaren Pendelauslenkungsauslöseschwellwert verbleibt, wird eine aktuelle, eingestellte Soll-Ziehgeschwindigkeit der Ziehvorrichtung, die insbesondere eine erste oder dritte Soll-Ziehgeschwindigkeit darstellt, im Wesentlichen konstant gehalten.
   Mit anderen Worten entspricht dieses Schaltkriterium bzw. dieser Schaltschritt einem Zustand, in dem die aktive Reduzierung bzw. Dämpfung nicht eingeschaltet ist, solange das aktuell ermittelte Ergebnis der maximalen Pendelauslenkung Ä unter dem vorgebbaren Pendelauslenkungsauslöseschwellwert liegt.

Zusätzlich oder alternativ:
II) Gemäß einem zweiten Schaltkriterium wird ein zweiter Schaltschritt vorzugsweise wie folgt ausgeführt: sobald das aktuell ermittelte Ergebnis der maximalen Pendelauslenkung Ä einen vorgebbaren Pendelauslenkungsauslöseschwellwert erreicht, wird im Wesentlichen sprunghaft von einer Soll-Ziehgeschwindigkeit, die insbesondere eine erste oder dritte Soll-Ziehgeschwindigkeit darstellt, auf ein vorgebbares Soll-Ziehgeschwindigkeitsintervall umgeschaltet, welches durch eine zweite obere und/oder eine zweite untere Soll-Ziehgeschwindigkeit begrenzt ist, wobei die zweite obere Soll-Ziehgeschwindigkeit um einen Betrag Δᵥ₂ₒ in Bezug auf die Soll-Ziehgeschwindigkeit angehoben wird und die zweite untere Soll-Ziehgeschwindigkeit um einen Betrag Δᵥ₂ᵤ in Bezug auf die Soll-Ziehgeschwindigkeit verringert wird, wobei insbesondere die Soll-Ziehgeschwindigkeit eine erste oder dritte Soll-Ziehgeschwindigkeit darstellt.
Mit anderen Worten wird bei diesem Schaltkriterium bzw. diesem Schaltschritt aufgrund der Erreichung des Pendelauslöseschwellwertes ausgehend von dem zuvor inaktiven Zustand die aktive Reduzierung bzw. Dämpfung in der beschriebenen Weise aktiviert.

Zusätzlich oder alternativ:
III) Gemäß einem dritten Schaltkriterium wird ein dritter Schaltschritt vorzugsweise wie folgt ausgeführt: solange das aktuell ermittelte Ergebnis der maximalen Pendelauslenkung Ä einen vorgebbaren Pendelauslenkungsauslöseschwellwert überschreitet, wird kontinuierlich im Wesentlichen bei jedem Nulldurchgangszeitpunkt t einer Pendelbewegung des Kristallstababschnitts in Bezug auf die Kristallpendelruheachse im Wesentlichen sprunghaft zwischen einer zweiten oberen Soll-Ziehgeschwindigkeit und einer zweiten unteren Soll-Ziehgeschwindigkeit umgeschaltet, wobei die zweite obere Soll-Ziehgeschwindigkeit um einen Betrag Δᵥ₂ₒ in Bezug auf eine Soll-Ziehgeschwindigkeit angehoben ist und die zweite untere Soll-Ziehgeschwindigkeit um einen Betrag Δv₂ᵤ in Bezug auf eine Soll-Ziehgeschwindigkeit verringert ist, wobei insbesondere die Soll-Ziehgeschwindigkeit eine erste oder dritte Soll-Ziehgeschwindigkeit darstellt.
Mit anderen Worten entspricht dieses Schaltkriterium bzw. dieser Schaltschritt einem Zustand, in dem die aktive Reduzierung bzw. Dämpfung eingeschaltet bzw. aktiviert ist und die Reduzierung bzw. Dämpfung in der oben beschrieben Weise vollführt, solange das aktuell ermittelte Ergebnis der maximalen Pendelauslenkung Ä den vorgebbaren Pendelauslenkungsauslöseschwellwert überschreitet,

Zusätzlich oder alternativ:
IV) Gemäß einem vierten Schaltkriterium wird ein vierter Schaltschritt wie folgt ausgeführt: sobald das aktuell ermittelte Ergebnis der maximalen Pendelauslenkung Ä einen vorgebbaren Pendelauslenkungsauslöseschwellwert unterschreitet,
a. wird im Wesentlichen sprunghaft von einer zweiten oberen Soll-Ziehgeschwindigkeit, welche um einen Betrag Δᵥ₂ₒ in Bezug auf eine erste oder dritte Soll-Ziehgeschwindigkeit angehoben ist, auf die erste oder dritte Soll-Ziehgeschwindigkeit umgeschaltet,
   und/oder
b. wird im Wesentlichen sprunghaft von einer zweiten unteren Soll-Ziehgeschwindigkeit, welche um einen Betrag Δv₂ᵤ in Bezug auf eine erste oder dritte Soll-Ziehgeschwindigkeit verringert ist, auf eine erste oder dritte Soll-Ziehgeschwindigkeit umgeschaltet.
Mit anderen Worten wird bei diesem Schaltkriterium bzw. diesem Schaltschritt aufgrund der Unterschreitung des Pendelauslöseschwellwertes ausgehend von dem Zustand der aktiven Reduzierung bzw. Dämpfung in den inaktiven Zustand geschaltet (d.h. die aktive Reduzierung bzw. Dämpfung wird ausgeschaltet).

Unter "im Wesentlichen sprunghaft" ist auch zu verstehen, dass auch ein rampenartiger, jedoch steiler, zeitlich verzögerter Anstieg um den Betrag Δᵥ₂ₒ oder Fall um den Betrag Δᵥ₂ₒ möglich ist, solange der Dämpfungseffekt ausreichend ist.

Es versteht sich, dass für die Funktionsweise der Schaltkriterien bzw. Schaltschritte es nicht zwingend erforderlich ist, exakt die maximale Pendelauslenkung oder die Pendelruheachse für die Ermittlung heranzuziehen; sofern die Periodendauer T des Pendeln im hohen einstelligen Sekundenbereich liegt, ist die Verzögerung der Signalverarbeitung bzw. des Eingreifens der Anlage vernachlässigbar.

Bei besonders vorteilhaften Varianten ist vorzugsweise vorgesehen, dass ein vorgebbarer Pendelauslenkungsauslöseschwellwert im Bereich von 0 mm bis 100,0 mm, vorzugsweise im Bereich von 0,1 mm bis 10,0 mm, weiter vorzugsweise im Bereich von 0,5 mm bis 3,0 mm liegt.

Zusätzlich oder alternativ kann eine vorgebbare, einstellbare Soll-Ziehgeschwindigkeit, insbesondere gemäß wenigstens einem Umschaltkriterium wie oben ausgeführt, im Bereich von 0 mm/min bis 10 mm/min, vorzugsweise im Bereich von 0,1 mm/min bis 4 mm/min, weiter vorzugsweise von 0,5 mm/min bis 3 mm/min, liegen.

Zusätzlich oder alternativ kann eine erste und/oder dritte Soll-Ziehgeschwindigkeit, insbesondere gemäß wenigstens einem Umschaltkriterium wie oben ausgeführt, im Bereich von 0 mm/min bis 10 mm/min, vorzugsweise im Bereich von 0,1 mm/min bis 4 mm/min, weiter vorzugsweise von 0,5 mm/min bis 3 mm/min, liegen.

Bei besonders vorteilhaften Varianten ist vorzugsweise vorgesehen, dass ein Betrag Δᵥ₂ₒ, welcher einen Soll-Ziehgeschwindigkeitsbetrag zwischen einer Soll-Ziehgeschwindigkeit, die insbesondere eine erste oder dritte Soll-Ziehgeschwindigkeit ist, und einer zweiten oberen Soll-Ziehgeschwindigkeit darstellt, im Bereich von 0,0001 mm/min bis 3 mm/min, vorzugsweise von 0,001 mm/min bis 0,1 mm/min, einstellbar ist. Vorzugsweise ist der Betrag Δ_{v2ο} über den wenigstens einen Zeitabschnitt konstant eingestellt oder während des wenigstens einen Zeitabschnittes innerhalb des Bereichs veränderbar einstellbar ist.

Zusätzlich oder alternativ kann ein Betrag Δᵥ₂ᵤ, welcher einen Soll-Ziehgeschwindigkeitsbetrag zwischen einer Soll-Ziehgeschwindigkeit, die insbesondere eine erste oder dritte Soll-Ziehgeschwindigkeit ist, und einer zweiten unteren Soll-Ziehgeschwindigkeit darstellt, im Bereich von 0,0001 mm/min bis 3 mm/min, vorzugsweise von 0,001 mm/min bis 0,1 mm/min, einstellbar sein. Vorzugsweise ist hierbei der Betrag Δᵥ₂ᵤ über den wenigstens einen Zeitabschnitt konstant eingestellt oder während des wenigstens einen Zeitabschnittes innerhalb des Bereichs veränderbar einstellbar.

Gemäß einem weiteren Aspekt betrifft die Erfindung eine Kristallziehvorrichtung zur Herstellung eines Einkristallstabs mit einer Ziehvorrichtung, wobei die Ziehvorrichtung dazu ausgebildet ist, während wenigstens eines Ziehprozess über die Ansteuerung der Ziehvorrichtung mit einer Steuervorrichtung einen im Wesentlichen sukzessiv fortschreitenden Einkristallstababschnitt mit einer einhergehenden im Wesentlichen sukzessiv fortschreitenden zugeordneten Einkristalllänge aus einer Schmelze gemäß einer einstellbaren, veränderbaren Soll-Ziehgeschwindigkeit der Ziehvorrichtung zu dem Einkristallstab zu ziehen, wobei die Kristallziehvorrichtung, vorzugsweise durch die Ziehvorrichtung, einen Pendeldrehpunkt D definiert, durch welchen im Wesentlichen entlang einer Höhenachse, eine definierte Kristallpendelruheachse verläuft.

Die Kristallziehvorrichtung ist erfindungsgemäß dazu ausgebildet, insbesondere ist die Steuervorrichtung der Kristallziehvorrichtung dazu ausgebildet, während wenigstens eines Zeitabschnittes des Ziehprozesses eine derart gezielte, veränderbare Einstellung der Soll-Ziehgeschwindigkeit über eine gezielte Ansteuerung der Ziehvorrichtung über die Steuervorrichtung vorzunehmen, dass sich jeweils nach einer vorgenommenen veränderten Einstellung der Soll-Ziehgeschwindigkeit für den weiter folgenden Ziehprozess maximale, auf die Kristallpendelruheachse bezogene, Pendelauslenkungen Ä des fortschreitenden Einkristallstababschnitts als Funktion der fortschreitenden Ziehzeit und/oder fortschreitenden Einkristalllänge ausbilden, deren Beträge und/oder deren Differenzbeträge aus aufeinanderfolgenden Beträgen, wenigstens abschnittsweise jeweils reduziert sind, insbesondere im Vergleich zu Beträgen und/oder Differenzbeträgen von maximalen Referenzpendelauslenkungen Â_{R}, die sich alternativ zu dem Ziehprozess in einem Referenzziehprozess jeweils bei einer identischen fortschreitenden Ziehzeit und/oder identischen fortschreitenden Einkristallstablänge an einem fortschreitenden Referenzeinkristallstababschnitt ausbilden würde, in welchem ein Referenzeinkristallstab gemäß einem referenzprozesstypischen Referenz-Soll-Ziehgeschwindigkeitsprofil gezogen wird.

Die erfindungsgemäße Kristallziehvorrichtung kann hierbei entweder mit einer Ziehvorrichtung nach Art einer Seilpendelvorrichtung oder kann mit einer Ziehvorrichtung nach Art einer konventionellen CZ-Ziehvorrichtung mit einer Gestängeeinheit ausgebildet sein. Die besonders vorteilhaften Effekte der Erfindung kommen jedoch insbesondere bei der Durchführung an einer Kristallziehvorrichtung mit einer Ziehvorrichtung nach Art einer Seilpendelvorrichtung gegenüber zum Tragen.

Mit der erfindungsgemäßen Kristallziehvorrichtung können die Vorteile analog zu dem oben im Detail beschriebenen erfindungsgemäßen Verfahren erzielt werden, sodass zur Vermeidung von Wiederholungen auf die obigen Ausführungen verwiesen wird. Generell wurde die Erfindung vorrangig anhand der Merkmale des Verfahrens gemäß der Erfindung oder gemäß seiner bevorzugten Varianten beschrieben. Es versteht sich, dass diese Merkmale (in Verbindung mit ihren beschriebenen Vorteilen) der bevorzugten Varianten des Verfahrens gleichermaßen für bevorzugte Varianten der Kristallziehvorrichtungen gelten, wobei die individuellen Vorrichtungskomponenten der Kristallziehvorrichtung dann entsprechend dazu ausgebildet sind, die zugehörigen Verfahrensschritte durchzuführen. Zur Vermeidung von Wiederholungen wird daher vollumfänglich auf die obigen Ausführungen verwiesen und an dieser Stelle zusammenfassend formuliert, dass bei bevorzugten Varianten der Kristallziehvorrichtung die Ziehvorrichtung vorzugsweise dazu ausgebildet ist, während wenigstens eines Ziehprozess über die Ziehvorrichtung einen im Wesentlichen sukzessiv fortschreitenden Einkristallstababschnitt mit einer einhergehenden im Wesentlichen sukzessiv fortschreitenden zugeordneten Einkristalllänge aus einer Schmelze gemäß einer einstellbaren, veränderbaren Soll-Ziehgeschwindigkeit der Ziehvorrichtung zu dem Einkristallstab nach dem beschriebenen erfindungsgemäßen Verfahren oder gemäß einem oder gemäß mehrerer seiner bevorzugten, beschriebenen Varianten des Verfahrens zu ziehen.

Gemäß einem weiteren Aspekt betrifft die Erfindung die Verwendung der Kristallziehvorrichtung (gemäß der Erfindung oder gemäß einer oder mehrerer ihrer bevorzugten, beschriebenen Varianten) zur Reduzierung von Pendelauslenkungen einer an einer Ziehvorrichtung hängenden Masseeinheit. Mit anderen Worten eignet sich die Verwendung der Kristallziehvorrichtung zur allg. Durchführung eines Arbeitsverfahren zur Reduzierung von Pendelauslenkungen einer an einer Ziehvorrichtung angehängten Masseeinheit (wie einleitend beschrieben bspw. u.a. Schmelzabdeckung).

Gemäß einem weiteren Aspekt betrifft die Erfindung ein Computerprogramm, umfassend Befehle, die bei der Ausführung des Programms durch eine Computervorrichtung (umfassend eine Prozessoreinheit) diesen veranlassen, über die Steuervorrichtung der erfindungsgemäßen Kristallziehvorrichtung (oder nach ihrer oben beschriebenen Varianten) gezielt deren Ziehvorrichtung für die Herstellung eines Kristallstabs unter verminderten Pendelauslenkungen nach dem erfindungsgemäßen Herstellungsverfahren (oder nach seinen oben beschriebenen Varianten) anzusteuern. Weiterhin betrifft die Erfindung ein computerlesbares Medium, auf dem dieses Computerprogramm gespeichert ist.

### Kurzbeschreibung der Figuren

**Figur 1** zeigt einen schematischen Schnitt durch eine Kristallziehvorrichtung 100 mit einer Ziehvorrichtung nach Art einer Seilpendelvorrichtung und illustriert schematisch eine Pendelauslenkung an einer Umlaufkante eines aktuellen Kristallstababschnitts während des erfindungsgemäßen Ziehprozesses.
**Figur 2** veranschaulicht den Effekt der Dämpfung der maximalen Pendelauslenkung für einen Zeitabschnitt während des Ziehprozesses ZP1 im Vergleich zum Process of Record (POR) über die fortschreitende Einkristallstablänge dargestellt.
**Figur 3** zeigt eine Detailansicht eines Ausschnitts während des Zeitabschnitts des Ziehprozesses ZP1 (ohne POR Vergleich), in welchem die aktive Dämpfung eingeschaltet und ausgeschaltet wird gemäß vorgebbaren Schaltschritten und Schaltkriterien I bis IV folgend.

### Bevorzugtes Ausführungsbeispiel

Die Kristallziehvorrichtung 100 ist zur Durchführung eines Verfahrens zur Herstellung eines Einkristallstabs aus Silizium ausgebildet und umfasst eine Ziehvorrichtung 110. Die Ziehvorrichtung 110 ist dazu ausgebildet, während eines Ziehprozesses ZP1 über die Ansteuerung der Ziehvorrichtung 110 mittels einer Steuervorrichtung 120 einen im Wesentlichen sukzessiv fortschreitenden Einkristallstababschnitt mit einer einhergehenden im Wesentlichen sukzessiv fortschreitenden zugeordneten Einkristalllänge aus einer Schmelze gemäß einer einstellbaren, veränderbaren Soll-Ziehgeschwindigkeit der Ziehvorrichtung 110 zu dem Einkristallstab zu ziehen.

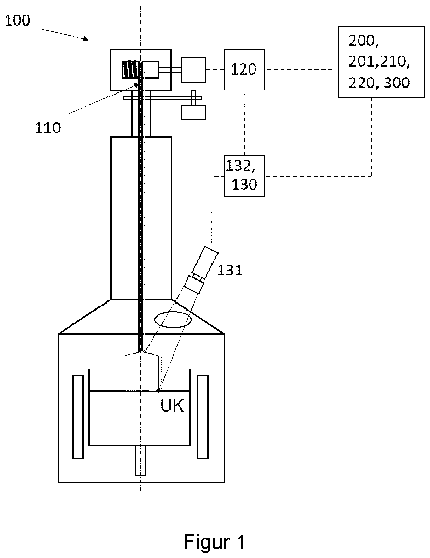

Die Ziehvorrichtung 110 der Kristallziehvorrichtung 100 ist nach Art einer Seilpendelvorrichtung ausgebildet. Die Ziehvorrichtung 110 definiert hierbei einen Pendeldrehpunkt D, durch welchen im Wesentlichen entlang einer Höhenachse H, eine definierte Kristallpendelruheachse verläuft. Um den Pendeldrehpunkt D (bzw. Aufhängepunkt) pendelt während des Ziehprozesses der Kristallstababschnitt nach Art von Pendelschwingungen in Bezug auf die Kristallpendelruheachse. Schematisch ist in Figur 1 eine aktuelle, maximale Pendelauslenkung (die einer Pendelschwingung zugeordnet ist) an einer aktuellen Umlaufkante eines aktuellen, ausgelenkten Kristallstababschnitts während des Ziehprozesses ZP1 gezeigt.

Der grundsätzliche Aufbau der Kristallziehvorrichtung 100 entspricht einer konventionellen Kristallziehvorrichtung und ist zusätzlich mit der speziellen Ausgestaltung der Steuervorrichtung zur gezielten Ansteuerung der Steuervorrichtung bzw. gezielten Einstellung der Soll-Ziehgeschwindigkeit zum Betrieb unter verminderter Pendelauslenkung ausgestaltet. Es wird daher nicht näher auf herkömmliche Komponenten einer Kristallziehvorrichtung eingegangen.

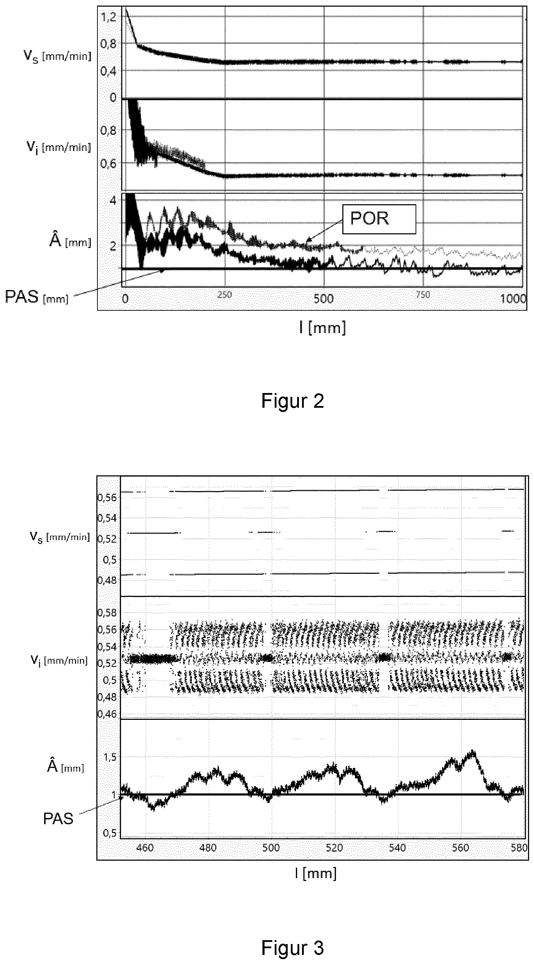

Die Steuervorrichtung 120 ist dazu ausgebildet, während eines Zeitabschnittes des Ziehprozesses ZP1 eine derart gezielte, veränderbare Einstellung der Soll-Ziehgeschwindigkeit vₛ über eine gezielte Ansteuerung der Ziehvorrichtung 110 vorzunehmen, dass sich jeweils nach einer vorgenommenen veränderten Einstellung der Soll-Ziehgeschwindigkeit für den weiter folgenden Ziehprozess maximale, auf die Kristallpendelruheachse bezogene, Pendelauslenkungen Ä des fortschreitenden Einkristallstababschnitts als Funktion der fortschreitenden Ziehzeit und fortschreitenden Einkristalllänge ausbilden, deren Beträge reduziert sind, im Vergleich zu Beträgen, die sich alternativ zu dem Ziehprozess in einem Referenzziehprozess (Process of Record, POR), siehe Figur 2, jeweils bei einer identischen fortschreitenden Ziehzeit und identischen fortschreitenden Einkristallstablänge an einem fortschreitenden Referenzeinkristallstababschnitt ausbilden würde, in welchem ein Referenzeinkristallstab gemäß einem referenzprozesstypischen Referenz-Soll-Ziehgeschwindigkeitsprofil gezogen wird. Konkret wird die Reduzierung (im Sinne einer Dämpfung) der auftretenden maximalen, auf die Kristallpendelruheachse bezogene, Pendelauslenkung innerhalb des Zeitabschnitts ausschließlich über die gezielte (kontinuierliche) Einstellung der Soll-Ziehgeschwindigkeit vorgenommen. Dieser Effekt der Dämpfung im Vergleich zum POR ist in Figur 2 für einen Zeitabschnitt während des Ziehprozesses ZP1 über die fortschreitende Einkristallstablänge dargestellt.

### Ermittlung des Verlaufs der aktuellen Pendelauslenkung während des Ziehprozesses ZP1:

Zur Ermittlung des Verlaufs der aktuellen Pendelauslenkung ist eine Pendelbewegungsermittlungsvorrichtung 130 vorgesehen. Eine Kameravorrichtung 131 der Pendelbewegungsermittlungsvorrichtung 130 zeichnet wenigstens einen Bildaufnahmebereich umfassend wenigstens einen Abschnitt einer Umlaufkante UK zwischen dem fortschreitenden Einkristallstababschnitt und der Schmelze kontinuierlich als Funktion der Zeit auf. Ein Teil der Umlaufkante UK ist in der schematischen Schnittdarstellung in Figur 1 als Punkt angedeutet. Weiterhin ist eine Verarbeitungsvorrichtung 132 der Pendelbewegungsermittlungsvorrichtung 130 vorgesehen, die wenigstens für den Abschnitt der Umlaufkante mit Mitteln der computerbasierten Bildverarbeitung deren zeitabhängige Ortskoordinaten ermittelt und auf Basis dieser Ortskoordinaten einen zeitabhängigen und kristalllängenabhängigen Verlauf (des Abschnitts) der Umlaufkante des Kristallstababschnitts nach Art von Pendelschwingungen des Kristallstababschnitts in Bezug auf die Kristallpendelruheachse und um den Pendeldrehpunkt D ermittelt, und für jede Pendelschwingung n, die zugeordnete Periodendauer T, Nulldurchgangszeitpunkt t sowie die maximale Pendelauslenkung Ä ermittelt. Schließlich ermittelt die Verarbeitungsvorrichtung 132 den Verlauf der aktuellen, maximalen Pendelauslenkung des Einkristallstababschnitts als Funktion der aktuellen Ziehzeit und der aktuellen Einkristalllänge.

Die Pendelbewegungsermittlungsvorrichtung 130 übermittelt kontinuierlich die Ergebnisse der Ermittlung zur weiteren Verwendung an eine Anzeigevorrichtung 210. Zusätzlich werden die Ergebnisse der Ermittlung zur weiteren Verwendung an eine Speichervorrichtung 220 übermittelt. Die Anzeigevorrichtung und die Speichervorrichtung sind Teil einer Computervorrichtung 200 umfassend eine Prozessoreinheit 201. Ein aktuelles Ergebnis wird zusätzlich an die Steuervorrichtung 120 übermittelt und, wenn das aktuell ermittelte Ergebnis der maximalen Pendelauslenkung einen vorgebbaren Pendelauslenkungsauslöseschwellwert PAS erreicht oder übersteigt oder unterschreitet, stellt die Steuervorrichtung 120 die Soll-Ziehgeschwindigkeit vₛ gezielt gemäß wenigstens einem Schaltschritt bzw. einem vorgebbaren Schaltkriterium folgend, wie im Folgenden beschrieben wird, veränderbar ein.

### Beschreibung der gezielten Einstellung der Soll-Ziehgeschwindigkeit vₛ während des Ziehprozesses ZP1:

Mit Verweis auf Figur 2 und insbesondere Figur 3 erfolgt nun für den herzustellenden Einkristallstab an der Kristallziehvorrichtung 100 eine kontinuierliche, veränderbare Einstellung der Soll-Ziehgeschwindigkeit vₛ in Reaktion darauf, wenn das aktuelle Ergebnis der maximalen Pendelauslenkung einen vorgebbaren Pendelauslenkungsauslöseschwellwert PAS erreicht oder übersteigt oder unterschreitet, der im vorliegenden Ausführungsbeispiel einen Wert von 1,5 mm aufweist.

Figur 3 zeigt eine Detailansicht eines Ausschnitts während des Zeitabschnitts Ziehprozesses ZP1, in welchem die aktive Dämpfung eingeschaltet und ausgeschaltet wird gemäß vorgebbaren Schaltschritten und Schaltkriterien I bis IV folgend, die nun beschrieben werden: Je nachdem, welche aktuelle Größe die ermittelte maximale Pendelauslenkung im Vergleich zum Pendelauslenkungsauslöseschwellwert PAS hat, folgt während des Zeitabschnittes des Ziehprozesses ZP1 die Einstellung der Soll-Ziehgeschwindigkeit einem der folgenden Schaltschritte bzw. wird die Einstellung gemäß einem vorgebbaren Schaltkriterium folgend vorgenommen (indem die Ziehvorrichtung 110 über die Steuervorrichtung 120 entsprechend angesteuert wird):
I) Gemäß einem ersten Schaltkriterium wird ein erster Schaltschritt wie folgt ausgeführt: solange das aktuell ermittelte Ergebnis der maximalen Pendelauslenkung Ä unter dem Pendelauslenkungsauslöseschwellwert PAS verbleibt, wird eine aktuelle, eingestellte erste Soll-Ziehgeschwindigkeit der Ziehvorrichtung 110 im Wesentlichen konstant gehalten.
II) Gemäß einem zweiten Schaltkriterium wird ein zweiter Schaltschritt wie folgt ausgeführt: sobald das aktuell ermittelte Ergebnis der maximalen Pendelauslenkung Ä den Pendelauslenkungsauslöseschwellwert PAS erreicht, wird im Wesentlichen sprunghaft von der ersten Soll-Ziehgeschwindigkeit auf ein vorgebbares Soll-Ziehgeschwindigkeitsintervall umgeschaltet, welches durch eine zweite obere und eine zweite untere Soll-Ziehgeschwindigkeit begrenzt ist, wobei die zweite obere Soll-Ziehgeschwindigkeit um einen Betrag Δᵥ₂ₒ in Bezug auf die erste Soll-Ziehgeschwindigkeit angehoben wird und die zweite untere Soll-Ziehgeschwindigkeit um einen Betrag Δᵥ₂ᵤ in Bezug auf die erste Soll-Ziehgeschwindigkeit verringert wird.
III) Gemäß einem dritten Schaltkriterium wird ein dritter Schaltschritt wie folgt ausgeführt: solange das aktuell ermittelte Ergebnis der maximalen Pendelauslenkung Ä den Pendelauslenkungsauslöseschwellwert PAS überschreitet, wird kontinuierlich im Wesentlichen bei jedem Nulldurchgangszeitpunkt t einer Pendelbewegung des Kristallstababschnitts in Bezug auf die Kristallpendelruheachse im Wesentlichen sprunghaft zwischen der zweiten oberen Soll-Ziehgeschwindigkeit und der zweiten unteren Soll-Ziehgeschwindigkeit umgeschaltet, wobei wiederum die zweite obere Soll-Ziehgeschwindigkeit um einen Betrag Δᵥ₂ₒ in Bezug auf die erste Soll-Ziehgeschwindigkeit angehoben ist und die zweite untere Soll-Ziehgeschwindigkeit um einen Betrag Δᵥ₂ᵤ in Bezug auf die erste Soll-Ziehgeschwindigkeit verringert ist.
IV) Gemäß einem vierten Schaltkriterium wird ein vierter Schaltschritt wie folgt ausgeführt: sobald das aktuell ermittelte Ergebnis der maximalen Pendelauslenkung Ä den Pendelauslenkungsauslöseschwellwert PAS unterschreitet, wird im Wesentlichen sprunghaft von der zweiten oberen Soll-Ziehgeschwindigkeit oder von der zweiten unteren Soll-Ziehgeschwindigkeit (je nach aktuellem Zustand vor dem Umschalten) auf die erste Soll-Ziehgeschwindigkeit umgeschaltet.

Die Wirkung der "aktiven" Dämpfung der Pendelauslenkung gemäß den Schaltkriterien im Vergleich zum POR sind in Figur 2 ersichtlich. Die Verläufe sind in Abhängigkeit der fortschreitenden Einkristalllänge dargestellt. Im vorliegenden Ausführungsbeispiel liegt die erste Soll-Ziehgeschwindigkeit bei einem Wert von 0,525 mm/min und der Betrag Δᵥ₂ₒ und der Betrag Δᵥ₂ᵤ, bei einer Größe von 0,04 mm/min. Weiterhin ist in Figur 2 und 3 auch der Verlauf der aktuellen Ist-Ziehgeschwindigkeit vᵢ [mm/min] dargestellt, welche sich im System in Reaktion auf die vorgegebene Soll-Ziehgeschwindigkeit einstellt. Figur 3 zeigt einen Detailausschnitt des Verlaufs aus Figur 2, welcher alle vier Schritte bzw. Schaltkriterien I bis IV beinhaltet.

Der unter verminderter Pendelauslenkung hergestellte Kristallstab wird anschließend der Kristallziehvorrichtung 100 entnommen und in einem weiterführenden Verfahren zur Herstellung einer Scheibe aus Halbleitermaterial unterzogen, welches folgende Schritte umfasst:
- Sägen des Einkristallstabs in dünne Scheiben,
- Chemische und mechanische Weiterbehandlung der dünnen Scheiben aus Halbmaterial, wobei die Weiterbehandlung die Weiterbehandlungsschritt Kantenverrunden, Läppen, Reinigen, und Polieren umfasst.

Das beschriebene Verfahren eignet sich generell zur Reduzierung von Pendelauslenkungen einer an einer Ziehvorrichtung hängenden Masseeinheit.

Weiterhin ist in dem Ausführungsbeispiel ein Computerprogramm vorgesehen, das Befehle umfasst, die bei der Ausführung des Programms durch eine Computervorrichtung 200 (umfassend einen Prozessor) diese veranlassen, über die Steuervorrichtung 120 der Kristallziehvorrichtung 100 gezielt deren Ziehvorrichtung 110 für die Herstellung des Kristallstabs unter verminderten Pendelauslenkungen nach dem beschriebenen Herstellungsverfahren anzusteuern. Dieses Computerprogramm ist auf einem computerlesbaren Medium 300 gespeichert.

## Patentansprüche

1. Verfahren zur Herstellung eines Einkristallstabs, insbesondere aus Silizium, mittels einer Ziehvorrichtung (110) einer Kristallziehvorrichtung (100), wobei ein Pendeldrehpunkt D durch die Kristallziehvorrichtung (100) definiert wird, durch welchen im Wesentlichen entlang einer Höhenachse eine definierte Kristallpendelruheachse verläuft,
wobei während wenigstens eines Ziehprozesses über die Ansteuerung der Ziehvorrichtung (110) mit einer Steuervorrichtung (120) ein im Wesentlichen sukzessiv fortschreitender Einkristallstababschnitt mit einer einhergehenden im Wesentlichen sukzessiv fortschreitenden zugeordneten Einkristalllänge aus einer Schmelze gemäß einer einstellbaren, veränderbaren Soll-Ziehgeschwindigkeit der Ziehvorrichtung (110) zu dem Einkristallstab gezogen wird,
wobei
während wenigstens eines Zeitabschnittes des Ziehprozesses eine derart gezielte, veränderbare Einstellung der Soll-Ziehgeschwindigkeit über eine gezielte Ansteuerung der Ziehvorrichtung (110) über die Steuervorrichtung (120) vorgenommen wird, dass sich jeweils nach einer vorgenommenen veränderten Einstellung der Soll-Ziehgeschwindigkeit für den weiter folgenden Ziehprozess maximale, auf die Kristallpendelruheachse bezogene, Pendelauslenkungen des fortschreitenden Einkristallstababschnitts als Funktion der fortschreitenden Ziehzeit und/oder fortschreitenden Einkristalllänge ausbilden, deren Beträge und/oder deren Differenzbeträge aus aufeinanderfolgenden Beträgen, wenigstens abschnittsweise reduziert sind, insbesondere im Vergleich zu Beträgen und/oder Differenzbeträgen von maximalen Referenzpendelauslenkungen, die sich alternativ zu dem Ziehprozess in einem Referenzziehprozess jeweils bei einer identischen fortschreitenden Ziehzeit und/oder identischen fortschreitenden Einkristallstablänge an einem fortschreitenden Referenzeinkristallstababschnitt ausbilden würden, in welchem ein Referenzeinkristallstab gemäß einem referenzprozesstypischen Referenz-Soll-Ziehgeschwindigkeitsprofil gezogen wird.

2. Verfahren nach Anspruch 1, wobei
die Reduzierung, insbesondere Dämpfung, der auftretenden maximalen, auf die Kristallpendelruheachse bezogene, Pendelauslenkung innerhalb des wenigstens einen Zeitabschnitts ausschließlich über die gezielte, und insbesondere kontinuierliche, Einstellung der Soll-Ziehgeschwindigkeit vorgenommen wird,
und/oder
die veränderbare Einstellung der Soll-Ziehgeschwindigkeit in Reaktion darauf vorgenommen wird, dass das aktuelle Ergebnis der maximalen Pendelauslenkung einen vorgebbaren Pendelauslenkungsauslöseschwellwert erreicht oder übersteigt oder unterschreitet, der im Bereich 0 mm bis 100,0 mm, vorzugsweise im Bereich von 0,1 mm bis 10,0 mm, weiter vorzugsweise im Bereich von 0,5 mm bis 3,0 mm liegt.

3. Verfahren nach Anspruch 1 oder 2, wobei
eine Kameravorrichtung (131) einer Pendelbewegungsermittlungsvorrichtung (130) wenigstens einen Bildaufnahmebereich umfassend wenigstens einen Abschnitt einer Umlaufkante zwischen dem fortschreitenden Einkristallstababschnitt und der Schmelze kontinuierlich als Funktion der Zeit aufzeichnet, und
eine Verarbeitungsvorrichtung (132) der Pendelbewegungsermittlungsvorrichtung (130) wenigstens für den Abschnitt der Umlaufkante mit Mitteln der computerbasierten Bildverarbeitung deren zeitabhängige Ortskoordinaten ermittelt und auf Basis dieser Ortskoordinaten wenigstens einen zeitabhängigen und/oder kristalllängenabhängigen Verlauf des Abschnitts der Umlaufkante des Kristallstababschnitts nach Art von Pendelschwingungen des Kristallstababschnitts in Bezug auf die Kristallpendelruheachse und um den Pendeldrehpunkt D ermittelt, und für jede Pendelschwingung n, die zugeordnete Periodendauer T, Nulldurchgangszeitpunkt t sowie die maximale Pendelauslenkung Ä ermittelt, und
die Verarbeitungsvorrichtung (132) weiterhin wenigstens den Verlauf der aktuellen, maximalen Pendelauslenkung des Einkristallstababschnitts als Funktion der aktuellen Ziehzeit und/oder der aktuellen Einkristalllänge ermittelt.

4. Verfahren nach Anspruch 3, wobei
mittels der Pendelbewegungsermittlungsvorrichtung (130) kontinuierlich die Ergebnisse der Ermittlung zur weiteren Verwendung an eine Anzeigevorrichtung (210) übermittelt werden und/oder die Ergebnisse der Ermittlung zur weiteren Verwendung an eine Speichervorrichtung (220) übermittelt werden, wobei die Anzeigevorrichtung (210) und die Speichervorrichtung (220) Teil einer Computervorrichtung (200) umfassend eine Prozessoreinheit (201) sind, und
das aktuelles Ergebnis der Ermittlung der maximalen Pendelauslenkung an die Steuervorrichtung (120) übermittelt wird und wenn das aktuelle Ergebnis der maximalen Pendelauslenkung einen vorgebbaren Pendelauslenkungsauslöseschwellwert erreicht oder unterschreitet oder überschreitet, stellt die Steuervorrichtung (120) die Soll-Ziehgeschwindigkeit gezielt, insbesondere gemäß wenigstens einem Schaltschritt und wenigstens einem vorgebbaren Schaltkriterium folgend, veränderbar ein.

5. Verfahren nach einem der vorherigen Ansprüche, wobei
wenigstens während des Zeitabschnittes des Ziehprozesses die Ziehvorrichtung (110), angesteuert über die Steuervorrichtung (120), die Einstellung der Soll-Ziehgeschwindigkeit in Abhängigkeit des aktuellen Ergebnisses der maximalen Pendelauslenkung, insbesondere ermittelt nach dem Verfahren und mittels der Pendelbewegungsermittlungsvorrichtung nach Anspruch 3 oder 4, gemäß wenigstens einem der folgenden Schaltschritte und einem vorgebbaren Schaltkriterium folgend vornimmt:
i gemäß einem ersten Schaltkriterium ein erster Schaltschritt wie folgt ausgeführt wird: solange das aktuell ermittelte Ergebnis der maximalen Pendelauslenkung Ä unter einem vorgebbaren Pendelauslenkungsauslöseschwellwert verbleibt, wird eine aktuelle, eingestellte Soll-Ziehgeschwindigkeit der Ziehvorrichtung, die insbesondere eine erste oder dritte Soll-Ziehgeschwindigkeit darstellt, im Wesentlichen konstant gehalten.
und/oder
ii gemäß einem zweiten Schaltkriterium ein zweiter Schaltschritt wie folgt ausgeführt wird: sobald das aktuell ermittelte Ergebnis der maximalen Pendelauslenkung Ä einen vorgebbaren Pendelauslenkungsauslöseschwellwert erreicht, wird im Wesentlichen sprunghaft von einer Soll-Ziehgeschwindigkeit, die insbesondere eine erste oder dritte Soll-Ziehgeschwindigkeit darstellt, auf ein vorgebbares Soll-Ziehgeschwindigkeitsintervall umgeschaltet, welches durch eine zweite obere und/oder eine zweite untere Soll-Ziehgeschwindigkeit begrenzt ist, wobei die zweite obere Soll-Ziehgeschwindigkeit um einen Betrag Δᵥ₂ₒ in Bezug auf die Soll-Ziehgeschwindigkeit angehoben wird und die zweite untere Soll-Ziehgeschwindigkeit um einen Betrag Δᵥ₂ᵤ in Bezug auf die Soll-Ziehgeschwindigkeit verringert wird, wobei insbesondere die Soll-Ziehgeschwindigkeit eine erste oder dritte Soll-Ziehgeschwindigkeit darstellt,
und/oder
iii gemäß einem dritten Schaltkriterium ein dritter Schaltschritt wie folgt ausgeführt wird: solange das aktuell ermittelte Ergebnis der maximalen Pendelauslenkung Ä einen vorgebbaren Pendelauslenkungsauslöseschwellwert überschreitet, wird kontinuierlich im Wesentlichen bei jedem Nulldurchgangszeitpunkt t einer Pendelbewegung des Kristallstababschnitts in Bezug auf die Kristallpendelruheachse im Wesentlichen sprunghaft zwischen einer zweiten oberen Soll-Ziehgeschwindigkeit und einer zweiten unteren Soll-Ziehgeschwindigkeit umgeschaltet, wobei die zweite obere Soll-Ziehgeschwindigkeit um einen Betrag Δᵥ₂ₒ in Bezug auf eine Soll-Ziehgeschwindigkeit angehoben ist und die zweite untere Soll-Ziehgeschwindigkeit um einen Betrag Δᵥ₂ᵤ in Bezug auf eine Soll-Ziehgeschwindigkeit verringert ist, wobei insbesondere die Soll-Ziehgeschwindigkeit eine erste oder dritte Soll-Ziehgeschwindigkeit darstellt,
und/oder
iv gemäß einem vierten Schaltkriterium ein vierter Schaltschritt wie folgt ausgeführt wird: sobald das aktuell ermittelte Ergebnis der maximalen Pendelauslenkung Ä einen vorgebbaren Pendelauslenkungsauslöseschwellwert unterschreitet,
wird im Wesentlichen sprunghaft von einer zweiten oberen Soll-Ziehgeschwindigkeit, welche um einen Betrag Δᵥ₂ₒ in Bezug auf eine erste oder dritte Soll-Ziehgeschwindigkeit angehoben ist, auf die erste oder dritte Soll-Ziehgeschwindigkeit umgeschaltet,
oder
wird im Wesentlichen sprunghaft von einer zweiten unteren Soll-Ziehgeschwindigkeit, welche um einen Betrag Δᵥ₂ᵤ in Bezug auf eine erste oder dritte Soll-Ziehgeschwindigkeit verringert ist, auf eine erste oder dritte Soll-Ziehgeschwindigkeit umgeschaltet.

6. Verfahren nach einem der vorherigen Ansprüche, wobei
ein vorgebbarer Pendelauslenkungsauslöseschwellwert im Bereich von 0 mm bis 100,0 mm, vorzugsweise im Bereich von 0,1 mm bis 10,0 mm, weiter vorzugsweise im Bereich von 0,5 mm bis 3,0 mm liegt,
und/oder
eine vorgebbare, einstellbare Soll-Ziehgeschwindigkeit und/oder erste Soll-Ziehgeschwindigkeit und/oder dritte Soll-Ziehgeschwindigkeit, insbesondere gemäß wenigstens einem Schaltschritt und einem vorgebbaren Schaltkriterium folgend, im Bereich von 0 mm/min bis 10 mm/min liegt.

7. Verfahren nach einem der vorherigen Ansprüche, wobei
ein Betrag Δᵥ₂ₒ, welcher einen Soll-Ziehgeschwindigkeitsbetrag zwischen einer Soll-Ziehgeschwindigkeit, die insbesondere eine erste oder dritte Soll-Ziehgeschwindigkeit ist, und einer zweiten oberen Soll-Ziehgeschwindigkeit darstellt, im Bereich von 0,0001 mm/min bis 3 mm/min, vorzugsweise von 0,001 mm/min bis 0,1 mm/min, einstellbar ist,
und/oder
ein Betrag Δᵥ₂ᵤ, welcher einen Soll-Ziehgeschwindigkeitsbetrag zwischen einer Soll-Ziehgeschwindigkeit, die insbesondere eine erste oder dritte Soll-Ziehgeschwindigkeit ist, und einer zweiten unteren Soll-Ziehgeschwindigkeit darstellt, im Bereich von 0,0001 mm/min bis 3 mm/min, vorzugsweise von 0,001 mm/min bis 0,1 mm/min, einstellbar ist.

8. Verfahren nach einem der vorherigen Ansprüche, wobei
das Verfahren an einer Kristallziehvorrichtung (100) mit einer Ziehvorrichtung nach Art einer Seilpendelvorrichtung durchgeführt wird,
oder
das Verfahren an einer Kristallziehvorrichtung (100) mit einer Ziehvorrichtung nach Art einer konventionellen CZ-Ziehvorrichtung mit einer Gestängeeinheit durchgeführt wird.

9. Kristallziehvorrichtung zur Herstellung eines Einkristallstabs mit einer Ziehvorrichtung (110), wobei die Ziehvorrichtung (110) dazu ausgebildet ist, während wenigstens eines Ziehprozess über die Ansteuerung der Ziehvorrichtung (110) mit einer Steuervorrichtung (120) einen im Wesentlichen sukzessiv fortschreitenden Einkristallstababschnitt mit einer einhergehenden im Wesentlichen sukzessiv fortschreitenden zugeordneten Einkristalllänge aus einer Schmelze gemäß einer einstellbaren, veränderbaren Soll-Ziehgeschwindigkeit der Ziehvorrichtung zu dem Einkristallstab zu ziehen,
wobei die Kristallziehvorrichtung, vorzugsweise durch die Ziehvorrichtung (110), einen Pendeldrehpunkt D definiert, durch welchen im Wesentlichen entlang einer Höhenachse, eine definierte Kristallpendelruheachse verläuft,
**dadurch gekennzeichnet, dass**
die Kristallziehvorrichtung (100), insbesondere die Steuervorrichtung (120) der Kristallziehvorrichtung (100), dazu ausgebildet ist, während wenigstens eines Zeitabschnittes des Ziehprozesses eine derart gezielte, veränderbare Einstellung der Soll-Ziehgeschwindigkeit über eine gezielte Ansteuerung der Ziehvorrichtung über die Steuervorrichtung (120) vorzunehmen, dass sich jeweils nach einer vorgenommenen veränderten Einstellung der Soll-Ziehgeschwindigkeit für den weiter folgenden Ziehprozess maximale, auf die Kristallpendelruheachse bezogene, Pendelauslenkungen des fortschreitenden Einkristallstababschnitts als Funktion der fortschreitenden Ziehzeit und/oder fortschreitenden Einkristalllänge ausbilden, deren Beträge und/oder deren Differenzen aus aufeinanderfolgenden Beträgen, wenigstens abschnittsweise jeweils reduziert sind, insbesondere im Vergleich zu Beträgen und/oder Differenzen von maximalen Referenzpendelauslenkungen, die sich alternativ zu dem Ziehprozess in einem Referenzziehprozess jeweils bei einer identischen fortschreitenden Ziehzeit und/oder identischen fortschreitenden Einkristallstablänge an einem fortschreitenden Referenzeinkristallstababschnitt ausbilden würde, in welchem ein Referenzeinkristallstab gemäß einem referenzprozesstypischen Referenz-Soll-Ziehgeschwindigkeitsprofil gezogen wird.

10. Kristallziehvorrichtung nach Anspruch 9, wobei die Kristallziehvorrichtung (100) das Verfahren nach einem der Ansprüche 1 bis 8 ausführt.

11. Verwendung der Kristallziehvorrichtung nach Anspruch 9 zur Reduzierung von Pendelauslenkungen einer an einer Ziehvorrichtung (110) hängenden Masseeinheit.

12. Computerprogramm, umfassend Befehle, die bei der Ausführung des Programms durch eine Computervorrichtung (200), umfassend eine Prozessoreinheit (201), diese veranlassen, über die Steuervorrichtung (120) der Kristallziehvorrichtung (100) nach Anspruch 9 oder 10 gezielt deren Ziehvorrichtung (110) für die Herstellung eines Kristallstabs unter verminderten Pendelauslenkungen nach dem Herstellungsverfahren nach einem der Ansprüche 1 bis 8 anzusteuern.

13. Computerlesbares Medium, auf dem das Computerprogramm nach Anspruch 12 gespeichert ist.

14. Verfahren zur Herstellung einer Scheibe aus Halbleitermaterial aus einem Einkristallstab, welcher unter verminderter Pendelauslenkung nach einem Verfahren zur Herstellung eines Einkristallstabs nach einem der Ansprüche 1 bis 8 hergestellt wurde, wobei ausgehend von dem Ende des Verfahrens zur Herstellung des Einkristallstabs wenigstens folgende Schritte folgen:
• Sägen des Einkristallstabs in dünne Scheiben,
• Chemische und/oder mechanische Weiterbehandlung wenigstens einer der dünnen Scheiben aus Halbmaterial, wobei die Weiterbehandlung wenigstens einen Weiterbehandlungsschritt aus Kantenverrunden, Läppen, Reinigen, Polieren, Abscheiden einer Oxidschicht, epitaktisches Wachsen einer einkristallinen Schicht, insbesondere Siliziumschicht, oder einer SiGe Schicht oder einer GaN Schicht, umfasst.
